# EUROPEAN PATENT SPECIFICATION

(11) **EP 1 647 964 B1**
(45) Date of publication and mention of the grant of the patent: **30.05.2012**
(21) Application number: 05256357.4
(22) Date of filing: 13.10.2005
(51) Int. Cl.: G09G 3/20, G09G 5/00

(54) **Virtual extended display information data (EDID) in a flat panel controller**
Virtuelle Extended Display Information Data (EDID) für eine Flachbildschirmsteuerung
Données d informations d affichage étendu (EDID) virtuelles dans un contrôleur d écran plat

(30) Priority: 18.10.2004 US 620094 P; 18.02.2005 US 61151
(43) Date of publication of application: 19.04.2006
(73) Proprietor: Tamiras Per Pte. Ltd., LLC, Dover, DE 19904 (US)
(72) Inventor: Noorbakhsh, Ali, Danville, CA 94506 (US); Keene, David, Corrales, NM 87048 (US); Lattanzi, John, Palo Alto, CA 94306 (US); Chilukuri, Ram, San Jose, CA 95129 (US)
(74) Representative: Kazi, Ilya

(56) References cited:
- US-A1- 2003 025 685
- US-A1- 2004 027 357
- US-B1- 6 618 773
- "DIGITAL VISUAL INTERFACE DVI" DIGITAL VISUAL INTERFACE DVI, XX, XX, no. REVISION 1.0, 2 April 1999 (1999-04-02), pages 1-76, XP002907715
- STENHOUSE H: "INTER-IC COMMUNICATIONS: THE I2C BUS" ELEKTOR ELECTRONICS, ELEKTOR ELECTRONICS, TUNBRIDGE WELLS, GB, vol. 16, no. 181, 1 September 1990 (1990-09-01), pages 15-17, XP000151469 ISSN: 0268-4519
- "ULTRA SIMPLE I2C INTERFACE FOR EEPROM" ELECTRONICS WORLD, NEXUS MEDIA COMMUNICATIONS, SWANLEY, KENT, GB, vol. 102, no. 1722, 1 May 1996 (1996-05-01), page 406, XP000597315 ISSN: 0959-8332

## Description

The invention relates to display devices. More specifically, the invention describes a method and apparatus for enabling a display device to access a single memory device that is capable of storing both digital and analog display information.

With computers, the Basic Input Output System (BIOS) queries the port of a computer to determine whether a monitor is present. If a monitor is present, the BIOS downloads standardized data that is typically contained at a read only memory (ROM) within the monitor. This standardized data is typically referred to as an Extended Display Identification Data (EDID) that contains information relating to the monitor that includes such information as the type, model, and functionality of the monitor. Typically, the BIOS contains a table that lists all of the various monitors that are supported by the computer. When a monitor is connected to the port, the BIOS reads selected information from the EDID and compares the EDID to the BIOS stored monitor data. The standard protocol requires the BIOS to read the monitor's information even when the monitor is powered off. In this case, a small amount of power is supplied by the computer through the monitor connector to the monitor to run and access the EDID storage device.

If a match between the EDID and the BIOS stored monitor data is found, the computer system is configured to utilize this particular type of monitor and its capabilities. For instance, if the monitor has a volume control or a sleep button, the computer is configured to support this functionality. However, if the information from the EDID does not match the BIOS stored monitor data, then the computer assumes that it is communicating with a "legacy" monitor. A legacy monitor is a term that refers to a monitor having basic functionality, such as a relatively older, outdated monitor. Thus, the BIOS configures the computer into a default configuration to operate with a legacy monitor.

Presently, a DDC monitor (Display Data Channel) includes a storage device, such as an EEPROM, that stores EDID regarding the capabilities of the monitor, such as the monitor's resolution and refresh rates. The EDID format is a standard data format developed by VESA (Video Electronics Standards Association) to promote greater monitor/host computer compatibility. At the present time, the current EDID format is described in Appendix D of Display Data Channel (DDC.TM.) Standard, version 1.0 revision 0, dated Aug. 12, 1994. For a personal computer utilizing a DDC monitor, the system software accesses the DDC related EDID that is stored-within the monitor. The system software also determines the type of video controller that is installed in the system. The video controller is used to control and configure the video data sent to the monitor. The system software then compares the refresh rate obtained from the DDC monitor to the capabilities of the video controller to determine the proper refresh rate to set at the video controller, which in turn controls the monitor.

Typically, EDID is display information accessible to the host even when the monitor is powered down. In monitors that support a "dual interface" (both analog and digital connectors supported), there are typically two separate standard EDID ROM devices, located on the flat panel controller board, that store the analog and digital EDID. The EDID is accessed via dedicated DDC bus. In the conventional dual panel flat panel controller design, the two EDID ROM devices, reside on flat panel controller, are powered from the host power supplies with analog cable (VGA DDC cable) for analog EDID ROM, and digital cable (DDC _DVI cable) for digital EDID ROM. The cost of having two EDID ROM devices on flat panel controller board is expensive.

US-6618713 discusses a system with a separate identification file for each of the monitor's two interfaces: analog and digital. The appropriate file is sent dependent on which interface is connected, if both connectors are connected, the digital file is sent.

The document "Digital Visual Interface" defines the DVI standard and mentions that EDID must be capable of being transmitted in a power-off state.

US-A-2003/0025685 relates to a control device that can judge whether a video signal input is analog or digital and on that basis control a DDC to switch EDID data according to the input signal.

The document "Inter-IC Communications: the I²C Bus" discusses the I²C bus for interconnecting integrated circuits.

The document "Ultra-simple I²C Interface for EEPROM" discusses an interface that needs only one capacitor to access an EEPROM which is I²C programmable via a PC.

Therefore, with the current cost pressure market, there is a need for a solution to support the EDID through DDC ports without having two separate EDID ROM devices.

A method and apparatus for supporting both analog and digital EDID from a single memory is described.

According to a first aspect of the present invention, there is provided a method of partitioning memory space of a single memory device in a display controller having a number of data ports each capable of being connected to an appropriate type video source and a processor arranged to process executable instructions and associated data as defined in appended claim 1. The method includes allocating a first portion of the memory space for storing the executable instructions and associated data, and allocating a second portion of the memory space for storing extended display information data, wherein the first and the second portions are always available for access by the data ports and/or the processor regardless of a power state of the display controller.

According to a second aspect of the invention, there is provided a display controller coupled to a display device by way of a display interface and to a host device by way of a data port as defined in appended claim 10. It includes a processor arranged to process executable instructions and associated data, a single memory device for storing the executable instructions and associated data and EDID corresponding to the display device, and a bridge portion coupling the single memory device to the host device by way of the data port, wherein the bridge portion is always in a powered on state thereby providing access to the single memory device by the host device even when the display controller is in a powered off state such that during a boot up process when the display controller is in the powered off state, the bridge portion and the single memory device are both powered by the host device such that the host device can access and retrieve the appropriate EDID from the single memory device as needed.

Embodiments of the invention will now be described by way of example with reference to the accompanying drawings, in which:
FIG. 1 shows a system that includes an implementation of an inventive display controller in accordance with an embodiment of the invention.
Fig. 2 shows a bridge circuit in accordance with an embodiment of the invention.
Fig. 3 shows a schematic of a cable and its associated channel in accordance with an embodiment of the invention.
Fig. 4 shows an exemplary auto activity detection circuit in accordance with an embodiment of the invention.
FIG. 5A shows a flowchart detailing a process in accordance with an embodiment of the invention.
Fig. 5B shows a flowchart detailing a process for acquiring extended display identification data (EDID) in a video controller having a processor for processing executable instructions and associated data and a number of data ports in accordance with an embodiment of the invention.
FIG. 5C shows a flowchart that details a process for arbitrating the acquisition of extended display information data (EDID) in accordance with an embodiment of the invention.
FIG. 5D shows a flowchart that details a process for the acquisition of EDID using inter-IC (IC2) protocol in accordance with an embodiment of the invention.
FIG. 5E shows a flowchart that details a power management procedure in accordance with an embodiment of the invention.
FIG. 5F shows a flowchart that details a process for power switching in a display controller in accordance with an embodiment of the invention.
FIG. 6 illustrates a graphics system in which the inventive circuit can be employed.

Reference will now be made in detail to a particular embodiment of the invention, an example of which is illustrated in the accompanying drawings. While the invention will be described in conjunction with the particular embodiment, it will be understood that it is not intended to limit the invention to the described embodiment. To the contrary, it is intended to cover alternatives, modifications, and equivalents as may be included within the scope of the invention as defined by the appended claims.

A DDC monitor (Display Data Channel) includes a storage device, such as an EEPROM, that stores EDID regarding the capabilities of the monitor, such as the monitor's resolution and refresh rates. In monitors that support a "dual interface" (i.e. where both analog and digital connectors supported), there are typically two separate standard EDID ROM devices, located on the flat panel controller board that store the analog and digital EDID, respectively. In addition to the EDID ROM devices, monitors also include a monitor controller that itself includes a processor having associated program memory storage configured as a programmable ROM device typically arranged as a serial peripheral interface (SPI) flash serial ROM. SPI Flash ROM is required on FLAT Panel Controller board to keep essential firmware routine of controlling panel in itself. These routines will be called by our on-chip micro-controller to execute necessary commands at certain time. It should be noted that a serial peripheral interface (SPI) is an interface that enables the serial (i.e. one bit at a time) exchange of data between a number of devices (at least one called a master and the others called a slave) that operates in full duplex mode. By full duplex, it is meant that data can be transferred in both directions at the same time. The SPI is most often employed in systems for communication between the central processing unit (CPU) and peripheral devices. It is also possible to connect two microprocessors by means of SPI.

With this in mind, the invention takes advantage of any unused portion(s) of the processor memory (such as the SPI flash serial ROM) to store the EDID thereby eliminating the costly use of extraneous memory devices to store EDID. In this way, by using the SPI Flash ROM already available to the processor to store the EDID, the invention eliminates the costs of having separate ROMs that were heretofore dedicated to storing the EDID only. In this way, the EDID is made available to the DDC ports (both analog and digital, if necessary) without having two separate EDID ROM devices.

The invention will now be described in terms of a display controller circuit. It should be noted that although the display controller is described in terms of a flat panel display controller suitable for use in any number and kind of flat panel display monitors, the inventive controller circuit is suitable for any type display deemed appropriate. Accordingly, the flat panel display described herein includes liquid crystal display (LCD) type monitors suitable for use with computers and any other device requiring a display.

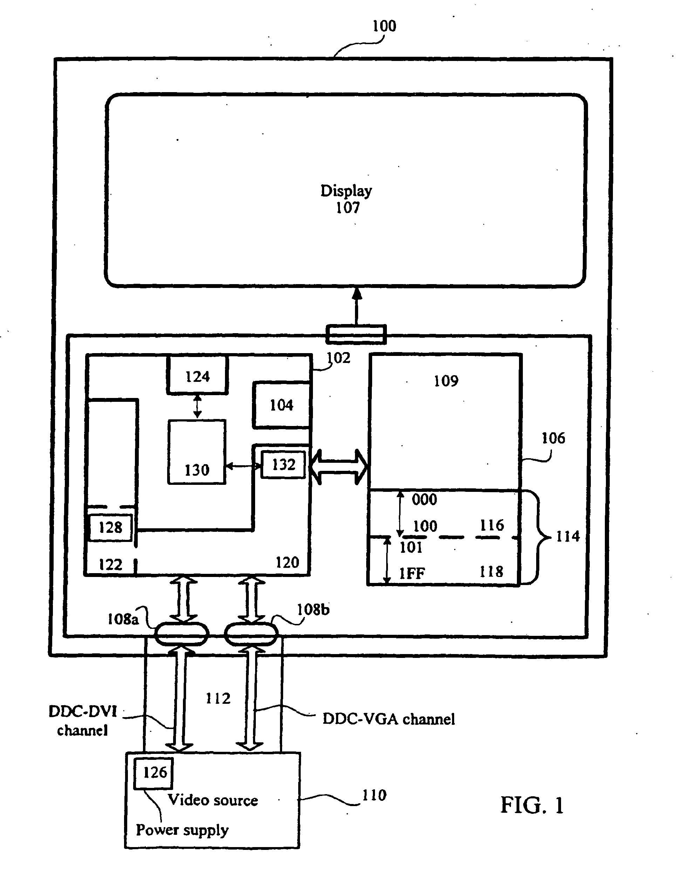

FIG. 1 shows a system 100 that includes an implementation of an inventive display controller 102 in accordance with an embodiment of the invention. As shown, the display controller 102 includes a processor 104 coupled to a memory device 106 in the form of an SPI-ROM 106 arranged to store both the EDID associated with a display 107 at specific memory locations separate and distinct from those memory locations 109 to store executable instructions and associated data processed by the processor 104. In the described embodiment, the system 100 also includes a number of data ports 108 that provide a transmission link between an external video source 110 (such as a computer or PC host) and the display controller 102. Generally speaking, the system 100 can include any number and type of data ports 108, however, for sake of this discussion, the system 100 is taken to be a dual interface type system that includes a Display Data Channel (DDC) type digital port (referred to as DDC-DVI port 108a) and a DDC analog data port (referred to as DDC-VGA port 108b). The display controller 102 is coupled to the video source 110 by way of a cable 112 using the DDC-VGA port 108b for analog displays and the DDC-DVI port 108a for digital displays. It should be noted that the DDC standard is a standard that defines a communication channel between a monitor and a display adapter included in a video source to which it is connected. The monitor uses this channel to convey its identity and capabilities to the display adapter.

In the described embodiment, the SPI-ROM 106 is partitioned to include a virtual EDID portion 114 that in turn is partitioned into an analog EDID portion 116 used to store analog display data and a digital EDID portion 118 used to store digital display data. In a particular implementation, the analog EDID portion 116 spans memory locations 000-100 whereas the digital EDID portion 118 spans memory locations 101-1FF but can, of course, be arranged in any manner deemed appropriate.

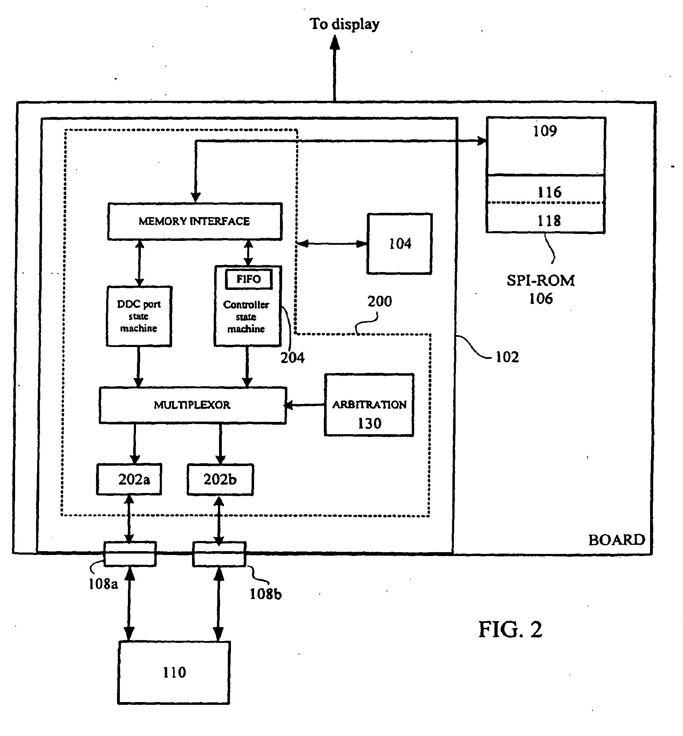

A portion of the controller 102 is partitioned into what is referred to as a bridge section 120 that acts as a bridge between the DDC-VGA port 108b and the DDC-DVI port 108a and the SPI Flash ROM 106. (The bridge section 120 is described in more detail below with reference to FIG. 2). It should be noted, that the bridge section 120 also includes an analog portion 122. During operation, any EDID read request from one of the ports 108 is acted upon by the bridge section 120 by accessing that portion of the ROM 106 that stores the appropriate EDID (portion 116 for analog data and portion 118 for digital data). The bridge section 120, in turn, passes the data read from the SPI Flash ROM 106 back to the requesting port.

In the described embodiment, the controller 102 conforms to the Inter-IC bus (I2C) protocol that describes a communication link between integrated circuits having 2 active bi-directional wires called SDA (Serial DAta line) and SCL (Serial CLock line) and a ground connection. Every device connected to the I2C bus has its own unique address that can act as a receiver and/or transmitter, depending on the functionality. For example, an LCD driver is only a receiver, while a memory or I/O chip can be both transmitter and receiver.

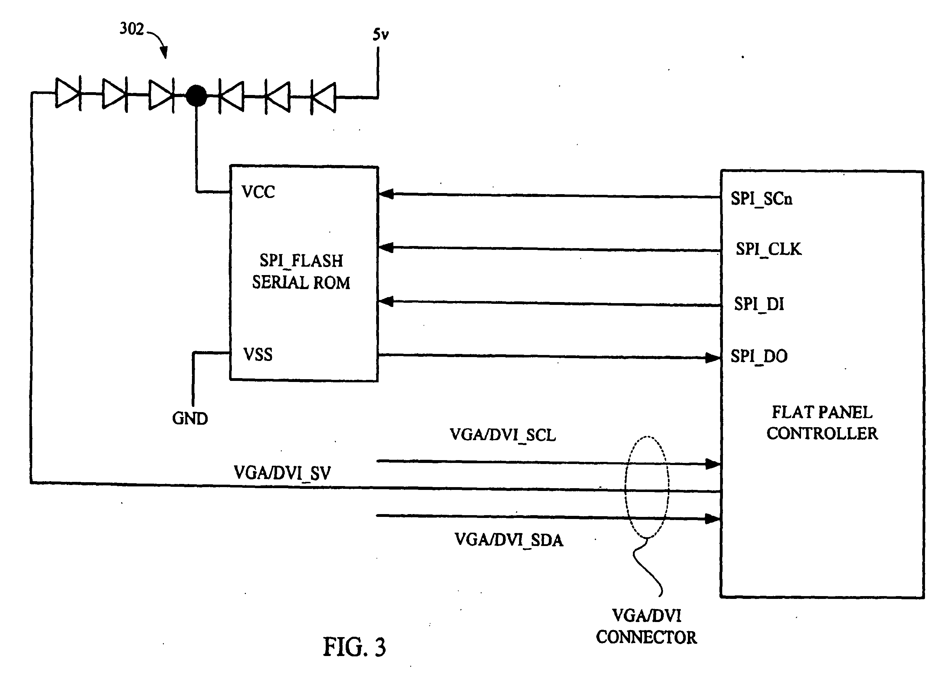

Accordingly, during an I2C burst read, the bridge section 120 converts each byte of EDID related data to serial bits of information and passes it over a 2-wire I2C bus of the requesting DDC port. During what is referred to as OFF_Mode, (during which an on-board power regulator 124 is OFF as detected by the analog portion 122) power from an external power supply 126 is supplied to the controller 102 and the SPI-ROM 106 by way of either of an active one of the DDC ports (i.e., DDC-DVI port 108a or DDC-VGA port 108b) via the cable 112 and its associated channel as shown in FIG. 3. In this way, even though the power regulator 124 included in the controller 102 is powered off, the bridge section 120 and the ROM 106 still receive sufficient power to provide the necessary EDID during boot-up. During a power switching transition (i.e., between the OFF_MODE when the on-board power regulator 124 is off and the ON_MODE when the on-board power regulator 124 is on, and vice versa) the analog portion 122 senses when the on-board power regulator 124 is switched from off to on, and vice versa. During the OFF-mode, both the bridge section 120 and the SPI FLASH ROM 106 are both supplied power by one or the other of the DDC ports 108 by way of the cable 112. In the described embodiment, the power supply 126 acts to provide power through two branches of cascaded diodes 302 shown in FIG. 3 (it should be noted that for simplicity, only one of the connectors is shown). In order to avoid latch up problems in the Off_Mode (when essentially the only portion of the controller 102 that is powered is the bridge section 120) digital logic in the bridge section 120 is set to known state.

In the case when the power goes from OFF to ON, the analog section 122 detects the on-board regulator 124 being active and providing power and as a result switches from the active one of the DDC ports 108 that is providing power from the power supply 126 to the now active on-board regulator 124. In this way, the bridge section 120 is always receiving power since any power transition between on-board and off-board power supplies is detected and the appropriate switching action is taken thereby avoiding any power switching glitches.

It should be noted that during a power transition from OFF to ON (i.e., when the power regulator 124 is turned on) any unfinished EDID read cycle is allowed to continue to the end of its cycle. In the context of this discussion, an unfinished EDID read cycle is that situation when the requesting DDC port is reading the EDID from the ROM 106 and the I2C STOP condition has not reached yet. During the period of time required to complete the EDID read operation, the controller 102 waits for the end of the unfinished EDID read cycle before switching to the On Mode for any subsequent EDID read request. During the time when the on-board power regulator 124 is turned on (On-Mode), the bridge section 120 arbitrates between service requests of the processor 104 for other client devices and EDID read requests from the ports 108 to the SPI FLASH ROM 106.

An auto activity detection circuit 128 (described in more detail below) located in the analog portion 122 of the bridge section 120 is designed to detect when the power regulator 124 in the controller 102 is powered on or off. In the described embodiment, the detecting is based upon a determination of a current T_{CLK} activity, where T_{CLK} is flat panel controller internal clock. For example, in the case where the T_{CLK} activity indicates that an on-board crystal clock is active, then the power regulator 124 is determined to be on, whereas, a low T_{CLK} activity indicates that the power regulator 124 is determined to be off.

Since there is a limited power budget during the Off Mode, an RC based low frequency clock is activated to drive the bridge circuit 120 and an SPI _Flash ROM clock when the on-board power regulator 124 is off. However, during the On Mode the low frequency clock is turned off and the on-board crystal clock is activated since power for both the SPI_Flash ROM 106 and the bridge circuit 120 is then provided from the on-board power regulator 124. In this way, by seamlessly switching clocks, no glitch or malfunction during the EDID read or flat panel controller operation is likely to occur.

During the power-off mode, the power required for the virtual EDID operation is generated by the power supply 126 and provided by way of the cables 112. However, in the power on mode, the current requirement would increase since the controller 102 would be operating at a higher clock frequency. In this situation, the cable 112 would not be able to sustain the necessary current and, therefore, it is necessary to switch from the cable 112 to the onboard power supply 124. However, there are two conditions that need to be met to enable this switching. In any display product, there is a requirement for a reference clock (T_{LCK}) that can be generated with internal oscillator, external oscillator or clock source. The presence of this clock indicates that the chip is in power-on mode. The auto activity detection circuit 128 looks at this the clock signal T_{CLK} and charges a capacitor based on whether it is toggling or low. The capacitor voltage drives an amplifier or inverter and causes a logic state change if it exceeds the threshold voltage of the amplifier or inverter. For example, in the display products, there is generally a microcontroller interface and it is possible to change the register bits once the controller is in power on mode. As explained above, the T_{CLK} signal itself is sufficient to do the power switching. To make the system more robust, in addition to the T_{CLK}, a signal from the register bits is detected, which in the power off mode is low, or "0". Once the power is on, however, this bit can be programmed to high, or "1" using low frequency mode. The logic combination of this bit and T_{CLK} (act and /act) is used to do the power switching.

Since the described controller 102 is I2C compliant, the I2C protocol specification states that any circuit connected to an I2C bus that initiates a data transfer on the bus is considered to be the bus master relegating all other circuits connected to the bus at that time be regarded as bus slaves. In the I2C protocol, when the slave cannot keep up with a master read or write command, the slave holds the bus (i.e., stalling the bus activity) by holding the I2C clock (one of two wire I2C) to low (referred to as clock stretching). Accordingly, since the controller 102 is slaved to the video source 110 (such as a PC host) as the master, when the PC host 110 wants to read EDID from the ROM 106 through either the DDC-VGA 108b or DDC-DVI port 108a, the VESA standard does not allow the controller 102 to hold either of the busses connected to the ports 108. In another words, the VESA standard assumes that the ROM 106 is always available and PC host 110 can read EDID from the ROM 106 through one or the other of the DDC ports 108. Therefore, in order to conform to the VESA standard and still remain I2C compliant, an arbitration circuit 130 provides for execution of both an EDID read request as well as request from other client devices inside controller 102 that require reading the ROM 106. In a particular embodiment, the arbitration scheme utilizes a FIFO 132 that holds EDID data read from ROM. While the requesting VGA DDC port reads the FIFO 132 (byte by byte), each byte of data is sent through the requesting DDC port (serial I2C port) bit by bit. When the FIFO 132 is almost empty, the FIFO 132 is again given access to the ROM 106 in order to satisfy any pending EDID read requests while other requesting clients are interrupted until such time as the FIFO 132 is replenished with appropriate data.

Fig. 2 shows a bridge circuit 200 in accordance with an embodiment of the invention. It should be noted that the bridge circuit 200 is a particular implementation of the bridge circuit 120 shown and described in FIG. 1. The bridge circuit 200 includes a DDC PORT controller block 202 (202a associated with port 108a and 202b associated with 108b) for each of the DDC ports 108. When the power regulator 124 is powered off (Off_Mode), power is supplied by either of DDC ports cable (VGA/DVI), feeding power to the bridge section of the chip and the SPI_FLASH ROM 106. During this time, one of the DDC PORT controller blocks 202 (VGA/DVI) is responsible for sending an EDID read request to an SPI state machine (SPI_SM) controller 204. The SPI_SM controller 204 acts upon the EDID read request to read requested data from the appropriate portion of the SPI Flash ROM 106 and pass the read data back to the appropriate DDC_PORT controller 202. The DDC_PORT controller 202, in turn, converts each byte of EDID related data to serial bits of information and passes it over the I2C bus of active DDC port 108.

As discussed above, in the I2C protocol, when the slave device cannot keep up with a master read or write command, the slave device can hold the bus (more like stalling the bus activity) from doing any more activity by holding I2C clock (one of two wire I2C) to low (clock stretching). In the described embodiment, the flat panel controller 102 is the slave device and PC host is the master. When the PC host wants to read EDID data from the ROM 106 through either the VGA DDC port 108b or DVI DDC port 108a, the VESA standard presumes that the ROM 106 is always available (i.e., the PC host can read EDID data from it through the DDC port 108). Therefore, the VESA standard does not provide for the slave device (controller 102) to hold the requesting DDC port 108 when data is not ready. Therefore, in order to maintain compliance with the VESA standard, the arbitration block 130 provides an arbitration service that enables processor 104 to keep up with both an EDID read request rate, as well as request from other circuits inside flat panel controller 102 demanding access to the ROM 106. In order to facilitate arbitrating ROM access requests, the FIFO 134 (which in this case is 8 bytes deep) holds EDID read from ROM 106. The requesting DDC port interface block reads the requested EDID from the FIFO 132 (byte by byte) and sends each byte of data through the requesting DDC port bit by bit to the PC host 110. When the FIFO 132 is almost empty, the processor 104 is flagged indicating that the processor 104 may be required to interrupt other requesting client devices in order to fill the FIFO 132 with additional requested EDID. In this way, the requesting DDC port is provided access to the ROM 106 as needed without the need to resort to clock stretching thereby maintaining compliance to the VESA standard. When the FIFO 132 is replenished, the processor 104 releases the flag and any other requesting client is permitted access to the ROM 106.

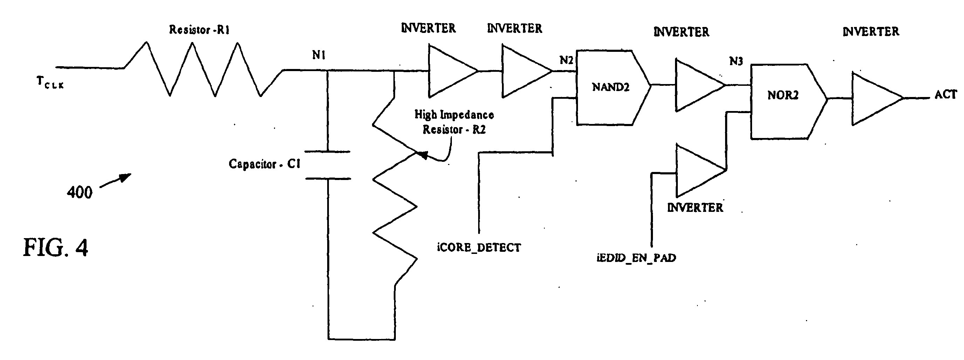

Fig. 4 shows an exemplary auto activity detection circuit 400 in accordance with an embodiment of the invention. The auto activity detection circuit 400 is designed to detect when the power regulator in the controller is powered on or off. When the power regulator is powered on, the T_{CLK} is toggling otherwise, the T_{CLK} is 0 when the power regulator is powered off. The auto activity detection circuit 400 will charge the capacitor C1 when the T_{CLK} is toggling and the node N1 will charge to high voltage causing node N2 to be high. If the iCORE_DETECT is set to high from the register control, node N3 will be high resulting in an output ACT signal to be high indicating that the controller power is on. The ACT can also be set to ONE by way of the iEDID_EN_PAD enable signal (which is a bond option signal).

Alternatively, when the T_{CLK} is zero, the capacitor C1 is not charging and the high impedance resistor R2 will pull down the Node N1 causing node N2 to be low which makes node N3 low resulting in the output ACT signal being low indicating that the controller power is off.

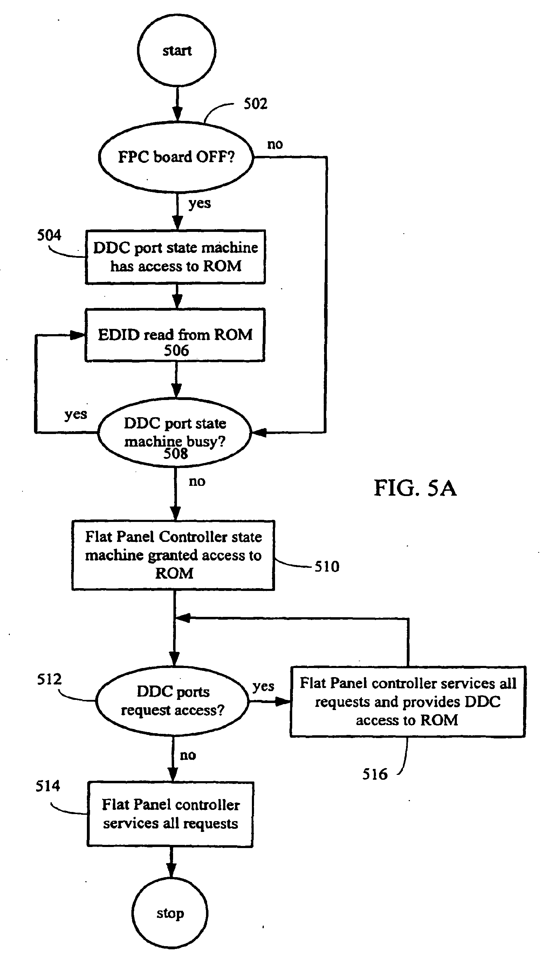

FIG. 5A shows a flowchart detailing a process 500 in accordance with an embodiment of the invention. The process 500 begins at 502 by a determination if the flat panel controller (FPC) is powered on. If the controller is determined to be powered on, the a DDC port state machine is granted access to the virtual EDID ROM at 504 and at 506, the requested EDID is read from the virtual EDID ROM and at 508 a determination is made whether or not the DDC port state machine is busy. Returning to 502, if, in the alternative, the controller has been determined to be powered off, then control is passed directly from 502 to 508 where if the DDC state machine is determined to be busy, then control is passed back to 506, otherwise, the controller state machine is granted access to the ROM at 510. At 512, a determination is made if other ports are requesting access to the ROM. If no other ports are requesting access, then the controller services all requests at 514, otherwise, at 516 the controller services all requests and provides any requesting port access to the ROM.

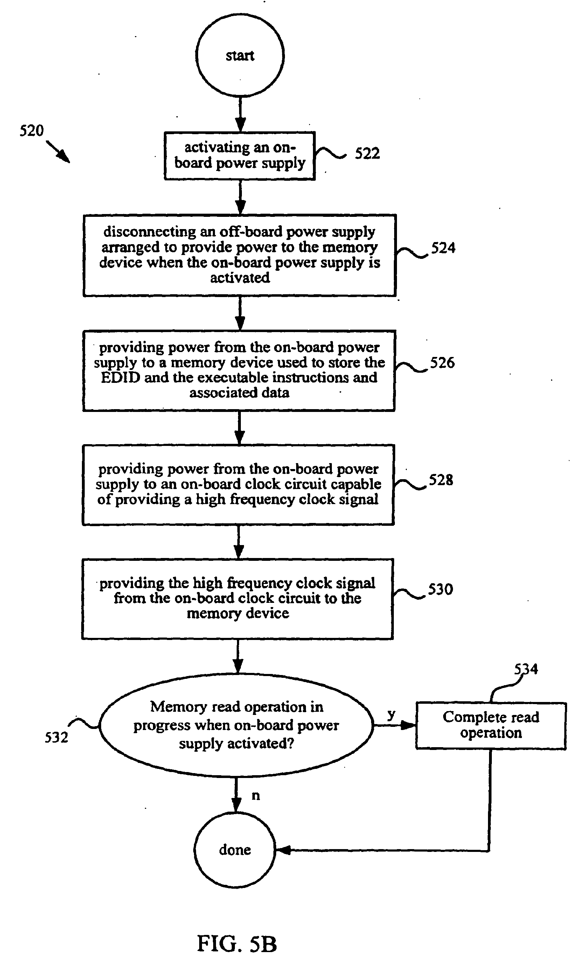

Fig. 5B shows a flowchart detailing a process 518 for acquiring extended display identification data (EDID) in a video controller having a processor for processing executable instructions and associated data and a number of data ports in accordance with an embodiment of the invention. The process 520 begins at 522 by activating an on-board power supply and at 524 disconnecting an off-board power supply arranged to provide power to the memory device when the on-board power supply is activated. Next at 526 providing power from the on-board power supply to a memory device used to store the EDID and the executable instructions and associated data and at 528 providing power from the on-board power supply to an on-board clock circuit capable of providing a high frequency clock signal. At 530, providing the high frequency clock signal from the on-board clock circuit to the memory device, and at 532 if a memory read operation was in progress when the on-board power supply was activated, then completing the memory read operation at 534.

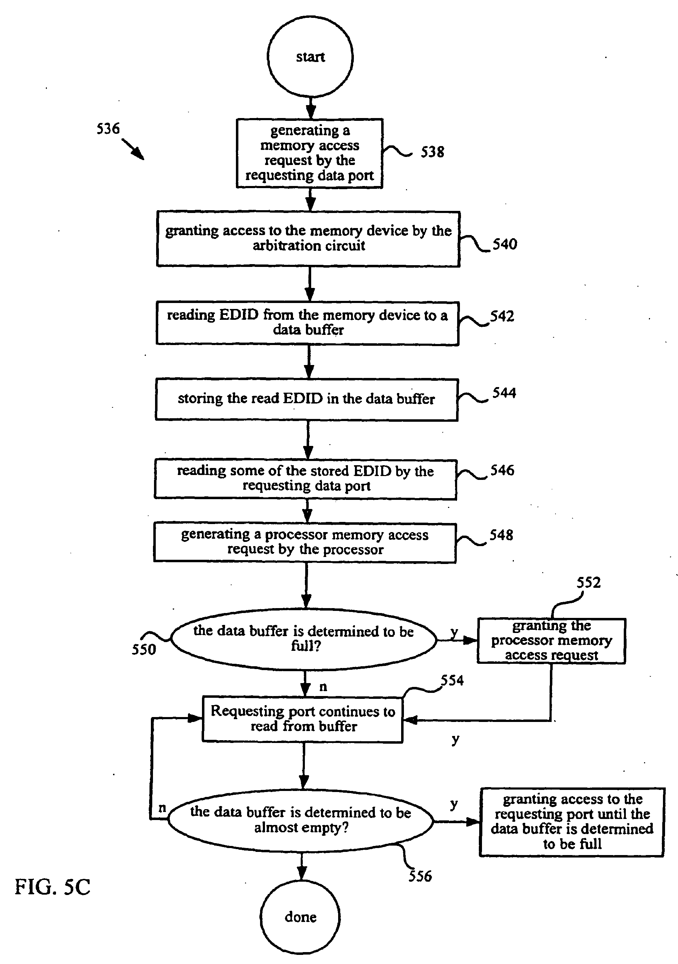

FIG. 5C shows a flowchart that details a process 536 for arbitrating the acquisition of extended display information data (EDID) in accordance with an embodiment of the invention. The process 536 begins at 538 by generating a memory access request by the requesting data port and at 540, granting access to the memory device by the arbitration circuit. At 542, reading EDID from the memory device to a data buffer and at 544 storing the read EDID in the data buffer and at 546 the requesting port reads some of the stored EDID by the requesting data port. At 548, generating a processor memory access request by the processor and at 550, a determination is made whether or not the data buffer is determined to full. If it is determined that the data buffer is full, then at 552 the processor memory access request is granted, and in any case, at 554 the requesting port continues to read from the buffer. At 556, a determination is made whether or not the buffer is almost empty and if it is determined to be almost empty, then at 558, the requesting port is granted access to the memory, otherwise, the requesting port continues to read data from the buffer.

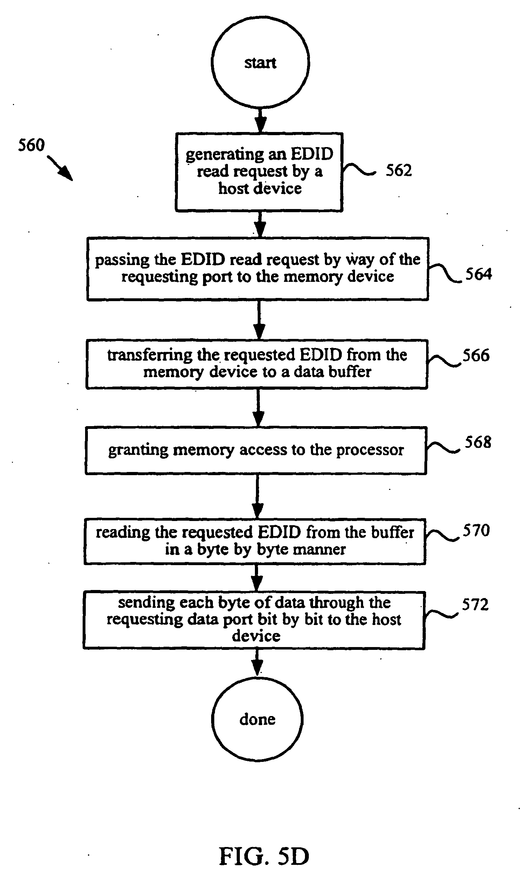

FIG. 5D shows a flowchart that details a process 560 for the acquisition of EDID using inter-IC (IC2) protocol in accordance with an embodiment of the invention. The process 560 begins at 562 by generating an EDID read request by the host device and at 564 passing the EDID read request by way of the requesting port to the memory device. At 566, the requested EDID is transferred from the memory device to a data buffer while at 568, memory access is granted to the processor, and at 570 reading the requested EDID from the buffer in a byte by byte manner; and sending each byte of data through the requesting data port bit by bit to the host device at 572. In this way, the requesting data port is provided access to the memory device as needed without clock stretching thereby maintaining compliance to the VESA standard.

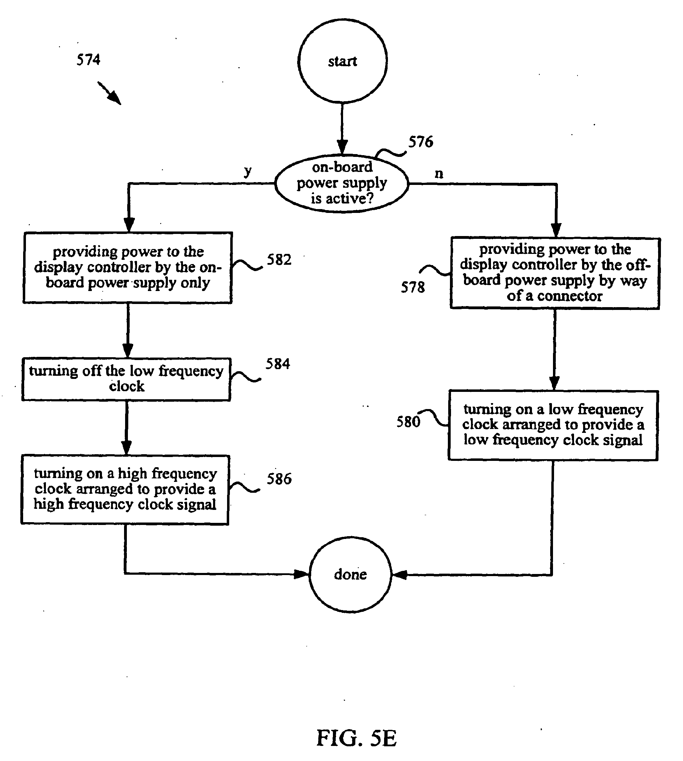

FIG. 5E shows a flowchart that details a power switching procedure 574 suitable for maintaining a low power budget in accordance with an embodiment of the invention. The process 574 begins at 576 by determining if an on-board power supply is active. If the on-board power supply is not active, then power is provided to the display controller by an off-board power supply by way of the connector at 578 and at 580 a low power, low frequency clock arranged to provide a low frequency clock signal is turned on thereby preserving power.

However, when at 576, it is determined that the on-board power supply is not active, then at 582 power is supplied to the display controller by the on-board power supply only and at 584, the low frequency clock is turned off and at 586, the high frequency clock arranged to provide a high frequency clock signal is turned on.

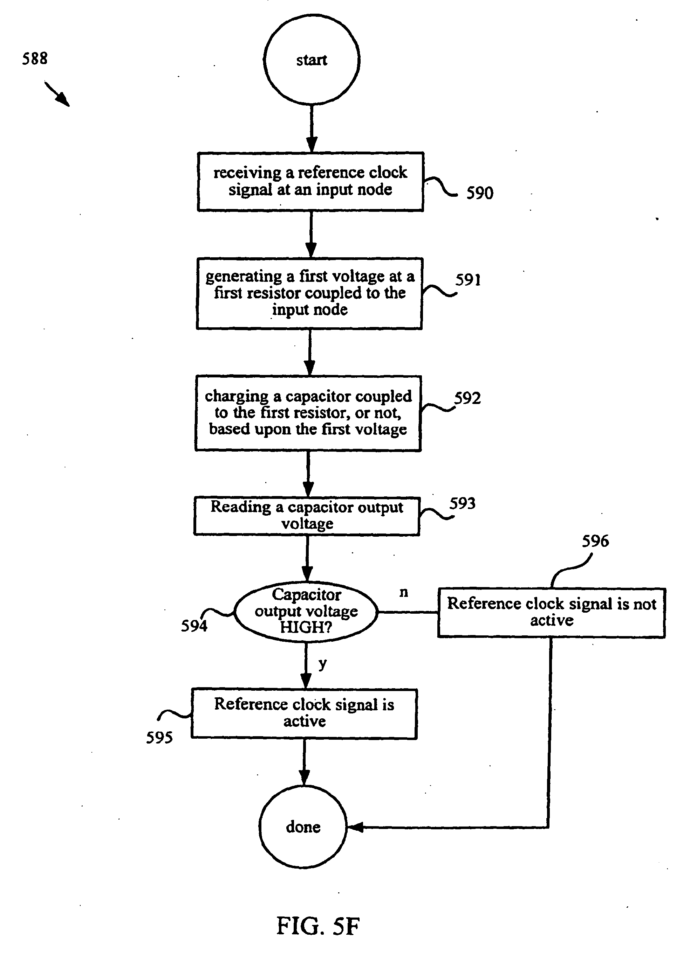

FIG. 5F shows a flowchart that details a process 588 for auto detecting of a active power supply in a display controller in accordance with an embodiment of the invention. The process 588 starts at 590 by receiving a reference clock signal at an input node and at 591 generating a first voltage at a first resistor coupled to the input node. At 592, charging a capacitor coupled to the first resistor, or not, based upon the first voltage and at 593, reading a capacitor output voltage. At 594, a determination is made whether or not the capacitor output voltage is HIGH and if it is determined to be HIGH, then at 595, the reference clock signal is determined to be active and on the other hand, if the capacitor output voltage is not HIGH, then at 596, the reference clock signal is determined to be not active.

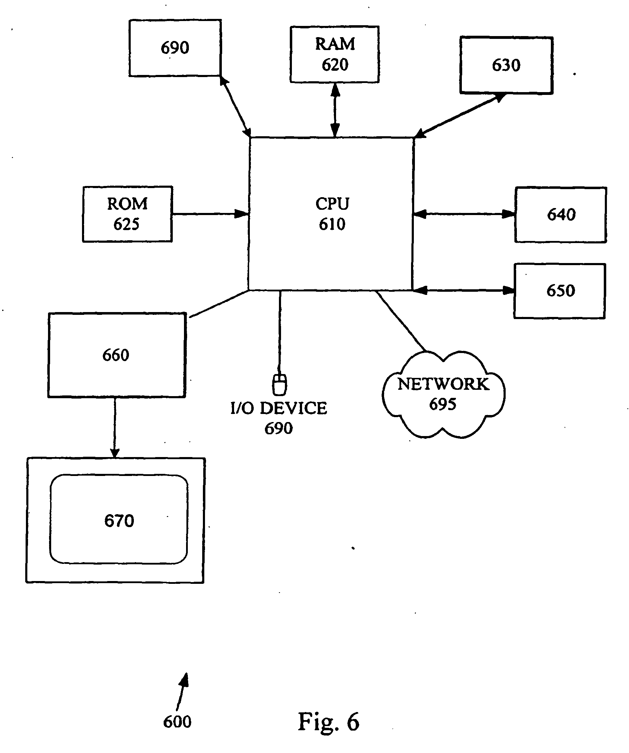

FIG. 6 illustrates a graphics system 600 in which the inventive circuit 602 can be employed. System 600 includes central processing unit (CPU) 610, random access memory (RAM) 620, read only memory (ROM) 625, one or more peripherals 630, primary storage devices 640 and 650, graphics controller 660, and digital display unit 670. CPUs 610 are also coupled to one or more input/output devices 690 that may include, but are not limited to, devices such as, track balls, mice, keyboards, microphones, touch-sensitive displays, transducer card readers, magnetic or paper tape readers, tablets, styluses, voice or handwriting recognizers, or other well-known input devices such as, of course, other computers. Graphics controller 660 generates image data and a corresponding reference signal, and provides both to digital display unit 670. The image data can be generated, for example, based on pixel data received from CPU 610 or from an external encode (not shown). In one embodiment, the image data is provided in RGB format and the reference signal includes the V_{SYNC} and H_{SYNC} signals well known in the art. However, it should be understood that the present invention could be implemented with image, data and/or reference signals in other formats. For example, image data can include video signal data also with a corresponding time reference signal.

Although only a few embodiments of the present invention have been described, it should be understood that the present invention may be embodied in many other specific forms without departing from the scope of the present invention. The present examples are to be considered as illustrative and not restrictive, and the invention is not to be limited to the details given herein, but may be modified within the scope of the appended claims along with their full scope of equivalents.

While this invention has been described in terms of a specific embodiment, there are alterations, permutations, and equivalents that fall within the scope of this invention. It should also be noted that there are many alternative ways of implementing both the process and apparatus of the present invention. It is therefore intended that the invention be interpreted as including all such alterations, permutations, and equivalents as fall within the scope of the present invention.

## Claims

1. A method of partitioning memory space of a single memory device (106) in a display controller (102) having a number of data ports (108) each capable of being connected to an appropriate type video source and a processor (104) arranged to process executable instructions and associated data, wherein the data ports (108) are each connected to the memory device (106) by way of 12C compliant data busses; the method comprising:
allocating a first portion (109) of the memory space for storing the executable instructions and associated data; and
allocating a second portion (114) of the memory space for storing extended display information data, wherein the first and the second portions (109,114) are always available for access by the data ports (108) and/or the processor (104) regardless of a power state of the display controller (102);
arbitrating retrieving appropriate EDID from the memory device (106) by the requesting port and processor memory access requests to as to maintain I2C compliance;
wherein, when an access request to the second portion (114) is generated (540) via a data port (108), the requested extended display information data is read (542) and stored (544) in a data buffer (132) for supply to the data port (108) and wherein the requesting data port (108) reads the requested extended display information data from the data buffer (132).

2. A method as recited in claim 1, wherein the allocating the second portion (114) of the memory space comprises:
allocating a third portion (116) of the second portion of the memory space for storing analog extended display information data; and
allocating a fourth portion (118) of the second portion of the memory space for storing digital extended display information data.

3. A method as recited in claim 2, wherein some of the data ports (108) are analog data ports and some of the data ports are digital data ports.

4. A method as recited in claim 3, wherein the analog data ports selectively retrieve the analog extended display information data.

5. A method as recited in claim 3, wherein the digital data ports selectively retrieve the digital extended display information data.

6. A method as recited in claim 1, further comprising:
providing power (578) to the memory device (106) by the host device (110) by way of selected ones of the data ports in a power_off mode; and
providing power (582) to the memory device (106) by on-board power supply only in a power on mode.

7. A method as recited in claim 3, wherein the digital port is a DVI port and wherein the analog port is a VGA port.

8. A method as recited in claim 7, further comprising:
determining if the display (107) is a digital display or an analog display;
activating the appropriate port based upon if the display is analog or digital, and
accessing the appropriate portion of the single memory device (106) based upon if the display is analog or digital.

9. A method as recited in any one of the preceding claims, further comprising, when a request to access the single memory device is generated (548) by the processor, determining (556) whether or not the data buffer is almost empty and, if it is almost empty, granting the data port access to the single memory device.

10. A display controller (102) coupled to a display device (107) by way of a display interface and to a host device (110) by way of a number of data ports (108), comprising:
a processor (104) arranged to process executable instructions and associated data; and
a single memory device (106) for storing the executable instructions (109) and associated data and EDID (114) corresponding to the display device (107) that is always available for access by the data ports (108) and/or the processor (104) regardless of a power state of the display controller (102);
**characterized in that** the data ports (108) are each connected to the memory device (106) by way of 12C compliant data busses;
and further comprising an arbitration circuit (130) for arbitrating execution of both an EDID read request via a data port (108) of the single memory device (106) and read requests of the processor (104) of the single memory device (106) to maintain 12C compliance; and
a data buffer (132) arranged for storing the requested EDID data read from the single memory device (106), and wherein the requesting data port (108) is arranged to read the requested extended display information data from the data buffer (132).

11. A display controller (102) as recited in claim 10, further comprising:
a bridge portion (120) coupling the data ports (108) and the single memory device (106), wherein the bridge portion (120) and the single memory device (106) are both powered by the host device (110) such that the host device (110) can access and retrieve the appropriate EDID from the single memory device (106) as needed in a power down mode..

12. A controller as recited in claim 10, wherein the single memory device (106) is a non-volatile random access memory device.

13. A controller as recited in claim 10, wherein the display controller (102) is a dual port controller suitably arranged to control an analog type display and/or a digital type display.

14. A controller as recited in claim 10, wherein the portion of the single memory device (106) allocated for storage of the EDID is further partitioned into an analog EDID portion (116) and a digital EDID portion (118).

15. A controller as recited in claim 14, further comprising:
a display type determinator arranged to determine if the display is an analog or digital display; and
a port activator coupled to the display type determinator arranged to activate an appropriate one of the ports based on the results of the determination of the display type.

## Patentansprüche

1. Verfahren zum Unterteilen von Speicherraum eines einzelnen Speichergeräts (106) in einer Anzeigesteuerung (102), die eine Anzahl von Datenports (108) aufweist, die jeweils an eine Videoquelle geeigneten Typs angeschlossen werden können, und einen Prozessor (104), der zur Verarbeitung ausführbarer Befehle und zugehöriger Daten ausgebildet ist, wobei die Datenports (108) jeweils an das Speichergerät (102) über I2C-konforme Datenbusse angeschlossen sind; wobei das Verfahren umfasst:
Zuteilen eines ersten Abschnitts (109) des Speicherraums zum Speichern der ausführbaren Befehle und zugehörigen Daten; und
Zuteilen eines zweiten Abschnitts(114) des Speicherraums zum Speichern von Extended Display Information Data, wobei der erste und der zweite Abschnitt (109, 114) immer für den Zugriff durch die Datenports (108) und/oder den Prozessor (104) verfügbar sind, unabhängig vom Stromversorgungszustand der Anzeigesteuerung (102);
Durchführen einer Arbitration bezüglich Abrufen geeigneter EDID von dem Speichergerät (106) durch den anfordernden Port und Prozessorspeicher-Zugriffsanforderungen, um I2C-Konformität beizubehalten;
wobei, wenn eine Zugriffsanforderung für den zweiten Abschnitt (114) erzeugt (540) über einen Datenport (108) wird, die angeforderten Extended Display Information Data gelesen (52) werden, und in einem Datenpuffer (132) gespeichert werden, zur Zufuhr zum Datenport (108), und wobei der anfordernde Datenport (108) die angeforderten Extended Display Information Data von dem Datenpuffer (132) liest.

2. Verfahren nach Anspruch 1, bei welchem das Zuteilen des zweiten Abschnitts (114) des Speicherraums umfasst:
Zuteilen eines dritten Abschnitts (116) des zweiten Abschnitts des Speicherraums zum Speichern analoger Extended Display Information Data; und
Zuteilen eines vierten Abschnitts (118) des zweiten Abschnitts des Speicherraums zum Speichern digitaler Extended Display Information Data.

3. Verfahren nach Anspruch 2, bei welchem einige der Datenports (108) analoge Datenports sind, und einige der Datenports digitale Datenports sind.

4. Verfahren nach Anspruch 3, bei welchem die analogen Datenports selektiv die analogen Extended Display Information Data abrufen.

5. Verfahren nach Anspruch 3, bei welchem die digitalen Datenports selektiv die digitalen Extended Display Information Data abrufen.

6. Verfahren nach Anspruch 1, welches weiterhin umfasst:
Bereitstellen von Strom (578) zu dem Speichergerät (106) durch das Host-Gerät (110) über ausgewählte Datenports in einer Betriebsart mit ausgeschaltetem Strom; und
Bereitstellen von Strom (582) zu dem Speichergerät (106) durch eine On-Board-Stromversorgung nur in einer Betriebsart mit eingeschaltetem Strom.

7. Verfahren nach Anspruch 3, bei welchem der digitale Port ein DVI-Port ist, und der analoge Port ein VGA-Port ist.

8. Verfahren nach Anspruch 7, welches weiterhin umfasst:
Bestimmen, ob die Anzeige (107) eine digitale Anzeige oder eine analoge Anzeige ist; Aktivieren des geeigneten Ports auf Grundlage davon, ob die Anzeige analog oder digital ist, und
Zugreifen auf den geeigneten Abschnitt des einzelnen Speichergeräts (106) auf Grundlage davon, ob die Anzeige analog oder digital ist.

9. Verfahren nach einem der voranstehenden Ansprüche, welches weiterhin umfasst, wenn eine Anforderung zum Zugriff auf das einzelne Speichergerät durch den Prozessor erzeugt wird (548), zu bestimmen (556), ob der Datenpuffer beinahe leer ist oder nicht, und dann, wenn er beinahe leer ist, den Datenport-Zugriff auf das einzelne Speichergerät zu gewähren.

10. Anzeigesteuerung (102), die über eine Anzeigeschnittstelle an ein Anzeigegerät (107) gekoppelt ist, und an ein Host-Gerät (110) über eine Anzahl von Datenports (108), wobei vorgesehen sind:
ein Prozessor (104), der dazu ausgebildet ist, ausführbare Befehle und zugehörige Daten zu verarbeiten; und
ein einzelnes Speichergerät (106) zum Speichern der ausführbaren Befehle (109) und zugehöriger Daten und EDID (114) entsprechend dem Anzeigegerät (107), das immer verfügbar für Zugriff durch die Datenports (108) und/oder den Prozessor (104) ist, unabhängig vom Stromversorgungszustand der Anzeigesteuerung (102);
**dadurch gekennzeichnet, dass** die Datenports (108) jeweils an das Speichergerät (106) über I2C-konforme Datenbusse angeschlossen sind;
und weiterhin eine Arbitrationsschaltung (130) vorgesehen ist, zur Durchführung einer Arbitration bezüglich Ausführung sowohl einer EDID-Leseanforderung über einen Datenport (108) des einzelnen Speichergeräts (106) und Leseanforderungen des Prozessors (104) des einzelnen Speichergeräts (106), um I2C-Konformität aufrechtzuerhalten; und
ein Datenpuffer (132) vorgesehen ist, der zum Speichern der angeforderten EDID ausgebildet ist, die von dem einzelnen Speichergerät (106) gelesen werden, und wobei der anfordernde Datenport (108) dazu ausgebildet ist, die angeforderten Extended Display Information Data von dem Datenpuffer (132) zu lesen.

11. Anzeigesteuerung (102) nach Anspruch 10, welche weiterhin aufweist:
einen Brückenabschnitt (120), der die Datenports (108) und das einzelne Speichergerät (106) koppelt, wobei der Brückenabschnitt (120) und das einzelne Speichergerät (106) beide von dem Host-Gerät (110) mit Strom versorgt werden, so dass das Host-Gerät (106) einen Zugriff durchführen kann und die geeigneten EDID je nach Erfordernis von dem einzelnen Speichergerät (106) abrufen kann, in einer Betriebsart mit abgeschaltetem Strom.

12. Steuerung nach Anspruch 10, bei welcher das einzelne Speichergerät (106) ein nichtflüchtiges Speichergerät mit wahlfreiem Zugriff ist.

13. Steuerung nach Anspruch 10, bei welcher die Anzeigesteuerung (102) eine Doppelportsteuerung ist, die geeignet dazu ausgebildet ist, eine Anzeige des Analogtyps und/oder eine Anzeige des Digitaltyps zu steuern.

14. Steuerung nach Anspruch 10, bei welcher der Abschnitt des einzelnen Speichergeräts (106), der zum Speichern der EDID zugeteilt ist, weiter in einen analogen EDID-Abschnitt (116) und einen digitalen EDID-Abschnitt (118) aufgeteilt ist.

15. Steuerung nach Anspruch 14, welche weiterhin aufweist:
eine Anzeigetyp-Bestimmungsvorrichtung, die dazu ausgebildet ist, zu bestimmen, ob die Anzeige eine analoge oder eine digitale Anzeige ist; und
eine Port-Aktivierungsvorrichtung, die mit der Anzeigetyp-Bestimmungsvorrichtung gekoppelt ist, und dazu ausgebildet ist, einen geeigneten Port unter den Ports zu aktivieren, auf Grundlage der Ergebnisse der Bestimmung des Anzeigetyps.

## Revendications

1. Procédé de partitionnement de l'espace mémoire d'un dispositif à mémoire unique (106) dans un contrôleur d'affichage (102) comprenant un certain nombre de ports de données (108), pouvant chacun être connectés à une source vidéo de type approprié et un processeur (104) conçu pour traiter des instructions exécutables et des données associées, dans lequel les ports de données (108) sont chacun connectés au dispositif de mémoire (106) par le biais de bus de données conformes I2C, le procédé consistant à :
affecter une première partie (109) de l'espace mémoire au stockage des instructions exécutables et des données associées ; et
affecter une deuxième partie (114) de l'espace mémoire au stockage des données d'informations d'affichage étendu EDID, les première et deuxième parties (109, 114) étant toujours accessibles par les ports de données (108) et/ou le processeur (104) indépendamment d'un état d'alimentation du contrôleur d'affichage (102) ;
arbitrer la récupération des EDID appropriées depuis le dispositif de mémoire (106) par le port demandeur et les demandes d'accès à la mémoire du processeur afin de maintenir la conformité I2C ;
dans lequel, lorsqu'une demande d'accès à la deuxième partie (114) est générée (540) via un port de données (108), les données d'informations d'affichage étendu demandées sont lues (542) et stockées (544) dans un registre tampon (132) pour être fournies au port de données (108) et dans lequel le port de données demandeur (108) lit les données d'informations d'affichage étendu demandées depuis le registre tampon (132).

2. Procédé selon la revendication 1, dans lequel l'affectation de la deuxième partie (114) de l'espace mémoire consiste à :
affecter une troisième partie (116) de la deuxième partie de l'espace mémoire au stockage de données d'informations d'affichage étendu analogiques ; et
affecter une quatrième partie (118) de la deuxième partie de l'espace mémoire au stockage de données d'informations d'affichage étendu numériques.

3. Procédé selon la revendication 2, dans lequel certains des ports de données (108) sont des ports de données analogiques et certains des ports de données sont des ports de données numériques.

4. Procédé selon la revendication 3, dans lequel les ports de données analogiques récupèrent sélectivement les données d'informations d'affichage étendu analogiques.

5. Procédé selon la revendication 3, dans lequel les ports de données numériques récupèrent sélectivement les données d'informations d'affichage étendu numériques.

6. Procédé selon la revendication 1, consistant en outre à :
fournir une alimentation (578) au dispositif de mémoire (106) par un dispositif hôte (110) par le biais de ports de données choisis dans un mode hors tension ; et
fournir une alimentation (582) au dispositif de mémoire (106) par une alimentation électrique embarquée uniquement dans un mode sous tension.

7. Procédé selon la revendication 3, dans lequel le port numérique est un port DVI et dans lequel le port analogique est un port VGA.

8. Procédé selon la revendication 7, consistant en outre à :
déterminer si l'affichage (107) est un affichage numérique ou un affichage analogique ;
activer le port approprié en se basant sur le fait que l'affichage est analogique ou numérique, et
accéder à la partie appropriée du dispositif à mémoire unique (106) en se basant sur le fait que l'affichage est analogique ou numérique.

9. Procédé selon l'une quelconque des revendications précédentes, consistant en outre, lorsqu'une demande d'accès au dispositif à mémoire unique est générée (548) par le processeur, à déterminer (556) si le registre tampon est presque vide ou non et, s'il est presque vide, à accorder au port de données l'accès au dispositif à mémoire unique.

10. Contrôleur d'affichage (102) couplé à un dispositif d'affichage (107) par le biais d'une interface d'affichage et à un dispositif hôte (110) par le biais d'un certain nombre de ports de données (108), comprenant :
un processeur (104) conçu pour traiter des instructions exécutables et des données associées ; et
un dispositif à mémoire unique (106) destiné au stockage des instructions exécutables (109) et des données associées et des EDID (114) correspondant au dispositif d'affichage (107) qui est toujours accessible par les ports de données (108) et/ou le processeur (104) indépendamment d'un état d'alimentation du contrôleur d'affichage (102) ;
**caractérisé en ce que** les ports de données (108) sont chacun connectés au dispositif de mémoire (106) par le biais de bus de données conformes 12C ,
et comprenant en outre un circuit d'arbitrage (130) pour arbitrer l'exécution à la fois d'une demande de lecture d'EDID par le biais d'un port de données (108) du dispositif à mémoire unique (106) et de demandes de lecture du processeur (104) du dispositif à mémoire unique (106) pour maintenir la conformité 12C , et
un registre tampon (132) conçu pour stocker les données d'EDID demandées lues à partir du dispositif à mémoire unique (106) et dans lequel le port de données demandeur (108) est conçu pour lire les données d'informations d'affichage étendu demandées depuis le registre tampon (132).

11. Contrôleur d'affichage (102) selon la revendication 10, comprenant en outre:
une partie de pont (120) couplant les ports de données (108) et le dispositif à mémoire unique (106), la partie de pont (120) et le dispositif à mémoire unique (106) étant tous deux alimentés par le dispositif hôte (110) de telle sorte que le dispositif hôte (110) puisse accéder aux EDID appropriées et les récupérer à partir du dispositif à mémoire unique (106) selon besoin dans un mode basse-consommation.

12. Contrôleur selon la revendication 10, dans lequel le dispositif à mémoire unique (106) est un dispositif de mémoire vive non volatile.

13. Contrôleur selon la revendication 10, dans lequel le contrôleur d'affichage (102) est un contrôleur à double port conçu de manière appropriée pour contrôler un affichage de type analogique et/ou un affichage de type numérique.

14. Contrôleur selon la revendication 10, dans lequel la partie du dispositif à mémoire unique (106) affectée au stockage des EDID est en outre partitionnée en une partie d'EDID analogique (116) et une partie d'EDID numérique (118).

15. Contrôleur selon la revendication 14, comprenant en outre :
un discriminateur du type d'affichage conçu pour déterminer si l'affichage est de type analogique ou de type numérique ; et
un activateur de port couplé au discriminateur du type d'affichage conçu pour activer celui approprié parmi les ports à partir des résultats de la détermination du type d'affichage.
